# EUROPÄISCHE PATENTSCHRIFT

(11) **EP 1 683 598 B1**
(45) Veröffentlichungstag und Bekanntmachung des Hinweises auf die Patenterteilung: **28.07.2010**
(21) Anmeldenummer: 06000409.0
(22) Anmeldetag: 10.01.2006
(51) Int. Cl.: B23K 1/015, H05K 3/34

(54) **Dampfphasen-Löten**
Vapour phase soldering
Brasage en phase vapeur

(30) Priorität: 25.01.2005 DE 102005003498
(43) Veröffentlichungstag der Anmeldung: 26.07.2006
(73) Patentinhaber: Linde AG, 80331 München (DE)
(72) Erfinder: Wandke, Ernst, 82538 Geretsried (DE)
(74) Vertreter: Kasseckert, Rainer

(56) Entgegenhaltungen:
- EP-A2- 0 681 418
- JP-A- 1 044 275

## Beschreibung

Die Erfindung betrifft ein Verfahren zum Vorwärmen und Abkühlen von Bauteilen vor und nach einer Dampfphasenbehandlung, insbesondere einem Dampfphasen-Löten von Leiterplatten oder Baugruppen. Ein derartiges Dampfphasen-Löten ist insbesondere zum Simultan-Löten von elektrischen Bauelementen auf Leiterplatten oder von verschiedenen elektrischen und/oder mechanischen Bauteilen unterschiedlichster Funktion und Größe geeignet.

Das Dampfphasen-Löten ist ein Lötverfahren aus der Gruppe der Reflow-Lötverfahren, bei denen ein bereits auf das Bauteil aufgebrachtes Lötmittel durch Erwärmen wieder flüssig gemacht wird und dadurch die gewünschten Kontakte hergestellt werden. Ein Beispiel für das Reflow-Löten an sich ist aus der EP 23 107 B1 bekannt.

Aus der WO 89/10817 A1 ist es bekannt, dass Leiterplatten und elektronische Bauelemente in einer Dampfphasenlötvorrichtung behandelt werden. Charakteristisch für diesen Prozess ist unter anderem, dass das Dampfphasenmaterial selbst eine absolut inerte Phase während des Lötprozesses erzeugt. Diese Eigenschaft geht aber wenige Zentimeter über der Dampfphasengrenze nahezu vollständig verloren. Dadurch erfolgen der wesentlich größere Teil der Abkühlung anders als bei Volltunnelmaschinen beim Reflow- oder Wellenlöten unter Sauerstoffeinfluss. Das hat insbesondere für oxidationsempfindliche Werkstoffe, wie z.B. bei der Verwendung von bleifreien Loten oder der Verarbeitung von Wafermaterial all die Nachteile, die eine Abkühlung in Luft hat. Diese Nachteile sind unter anderem die chemische Schädigung des Basismaterials, die Vemetzung von Flussmittelresten, die Verunreinigung durch schwer entfembare Verschmutzungen oder die Oxidation der Lötpunkte mit entsprechenden Oberflächenschädigungen.

Aus der WO 96/37330 ist es bekannt, dass der gesamte Bereich über der Dampfphase durch Stickstoff oder ein Edelgas inertisiert werden kann. Dieser Vorschlag ist in der Praxis nicht oder nur sehr aufwendig realisierbar. Der Grund dafür sind die Transportbewegungen und die daraus folgenden ungewollten Strömungen und Vermischungen, die bei der Schleusung des Werkstückträgers in den Lötraum erfolgen. Auch die relativ großen offenen Fenster mit Verbindung zur Atmosphäre und mit freien Austauschmöglichkeiten der geschützten Gasatmosphäre verschlechtern dieses Verfahren. Die Folge davon ist trotz größerem Gasverbrauch eine Atmosphäre, die den gewünschten Anforderungen (Bestsauerstoffgehalt < 1000 ppm, vorzugsweise unter 80 ppm) in keiner Weise entsprechen. Hinzu kommt noch, dass mit der einfachen Inertgasfüllung selbstverständlich der Kühlprozess nicht beeinflusst werden kann.

Aus der DE 38 09 268 C1 ist eine Lötvorrichtung für das Löten in der Dampfphase bekannt, bei der über die zu behandelnden Werkstücke eine kleine Haube gestülpt wird. Mittels der Haube soll eine dampffreie Zone entstehen.

Aus der DE 39 15 040 A1 ist ein Verfahren zum Vorwärmen und/oder Abkühlen von Bauteilen vor und/oder nach einer Dampfphasenbehandlung bekannt. Dieses Verfahren bildet den Oberbegriff des Anspruchs 1. Dort wird das Vorwärmen oder Abkühlen in gesteuerter Weise vorgenommen. Die oben angesprochenen Probleme bei Zutritt von Luftsauerstoff zu den erhitzten Bauteilen werden mit dieser Vorrichtung jedoch nicht gelöst.

Es ist daher Aufgabe der Erfindung, ein Verfahren zum Dampfphasen-Löten vorzuschlagen, bei dem während der Vorwärm- und Abkühlphase die Bauteile gegenüber den genannten negativen Einwirkungen einer Luftatmosphäre geschützt sind.

Diese Aufgabe wird erfindungsgemäß gelöst von einem Verfahren, bei dem das Vorwärmen und das Abkühlen unter einer Haube erfolgt, in die ein gewünschtes Gas, bevorzugt ein Inertgas oder ein Reaktivgas, eingeblasen wird. Neu ist also, dass der Abkühlprozess und der Aufheizprozess unter Einwirkung einer modifizierten Atmosphäre erfolgen. Diese verhindert eine Oxidation der heißen Bauteile. Ein reaktives Gas initiiert gewünschte Reaktionen, insbesondere Reduktionen. Alle oben genannten Fehler sind dadurch vermieden. Gekennzeichnet ist das erfindungsgemäße Verfahren dadurch, dass eine Haube vorgesehen ist, die der Größe des Bauteils angepasst ist und die mit dem Inertgas geflutet wird. Durch die Haube wird nur relativ wenig Gas benötigt und das Bauteil ist trotzdem geschützt. Erfindungsgemäß wird die Haube bereits in der Auf- oder Vorheizphase über das zu lötende Werkstück (die bestückte Leiterplatte, den zu lötenden Wafer oder die Hybridbaugruppe) gestülpt und während der gesamten Prozesszeit oder in der zeitlichen Abfolge und mit gesteuerter Gasmenge (eventuell auch gesteuerter Temperatur) begast.

Da die Haube eine Form hat, die dem Bauteil besonders angepasst ist, wird nur relativ wenig Gas benötigt. Bei runden Bauteilen empfiehlt sich eine zylindrische Haube, bei rechteckigen Bauteilen eine rechteckige. Die Haube ist in ihren Abmessungen nicht wesentlich größer als das Bauteil, sodass Verluste durch Transportverwirbellungen vermieden werden.

Als zu verwendende Gase haben sich Stickstoff, Kohlendioxid, Argon, Helium, Wasserstoff oder CF4 bewährt. Auch andere inerte oder auch gezielt chemisch aktive Gase (z. B. Reduktionsgase ) können bei Bedarf eingesetzt werden.

In einer Ausführung der Erfindung wird ein Spüldruck von > 1,0 bar eingestellt, wobei sich bevorzugt ein Druck zwischen 1,0 und 1,3 bar, besonders bevorzugt ein Druck zwischen 1,15 und 1,25 bar als geeignet gezeigt hat. Die Menge des eingeblasenen Gases ist abhängig vom zu lötenden Werkstück, der verwendeten Technologie und der Gestalt der Haube. Die Gasmenge liegt z. B. in der Größenordnung um 4 Kubikmeter pro Stunde, wenn das Bauteil eine Ausdehnung von ca. 20 cm Durchmesser hat und einzeln mit einer genau angepassten Haube gelötet wird.

Durch Verwendung eines Gases und der Abdeckhaube kann das Vorheizen deutlich beschleunigt werden. In diesem Fall kann ein erwärmtes Edelgas, z. B. Helium, aber auch Wasserstoff pur oder im optimierten Gemisch mit Stickstoff, Kohlendioxid, u.a. verwendet werden, das zusätzlich zur Ofenatmosphäre das Bauteil schneller erwärmt.

Auch die Abkühlphase kann durch Verwendung der erfindungsgemäßen Haube deutlich beschleunigt werden. So kann ein gekühltes Gas eingesetzt werden oder sogar kyrogene Gase, wie Kohlendioxid, welches bereits aus einer bei Raumtemperatur sich befindlichen Flasche durch Entspannung auf relativ tiefe Temperaturen gelangt. Für sehr schnelles Abkühlen könnte auch Stickstoff tiefkalt verwendet werden oder auch die o.g. für den Wärme- (ab- ) transport günstigen Gase oder Gasgemische. Eine weitere einfache Möglichkeit, den Abkühlprozess zu optimieren, ist die Steuerung über die Gasmenge.

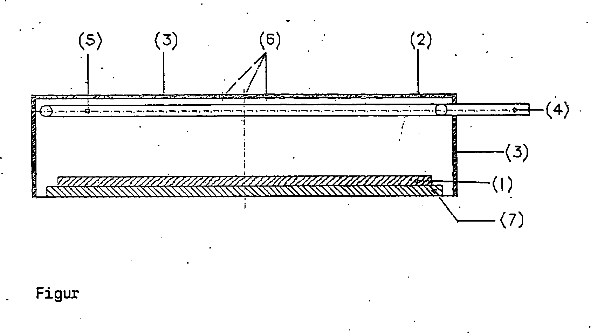

Eine Ausführung der Erfindung wird anhand der einzigen Figur näher erläutert. Die Figur zeigt ein Bauteil 1 mit dem dazu gehörigen Werkstückhalter 7, welches in einen Dampfphasen-Lötofen eingebracht ist. Der Dampfphasen-Lötofen ist hier nicht gezeigt. Das Bauteil befindet sich an der Stelle, an der die Obergrenze der Dampfphase beim Löten vorliegt. Oberhalb des Bauteils 1 befindet sich die Haube 2, die hier als Blechkonstruktion 3 ausgeführt ist und einen Gasanschlussstutzen 4 enthält. Im Inneren der Haube 2 befindet sich eine Lanze 5, die bevorzugt der Form der Haube 2 angepasst ist und über die das Inertgas verteilt wird. Die Lanze 5 ist hier als Ringleitung ausgeführt und enthält in gleichmäßigem Abstand kleine Löcher, die beispielsweise 2 mm Durchmesser haben, um den Stickstoff gleichmäßig in der Haube 2 zu verteilen. Auf dem Deckel der Haube sind in dieser Ausführung drei Löcher 6 mit 2 mm vorgesehen, die der Entlüftung der Haube 2 dienen. Das Bauteil 1 kann hier beispielsweise eine elektronische Baugruppe sein, die auf einem Silicium-Wafer aufgebaut ist.

Der Prozess beinhaltet in diesem Fall folgende Schrittfolgen und Parameter
1) Das vorbereitete Bauteil 1 wird in die Vapourphase-Maschine eingeschleust und mit der erfindungsgemäßen Haube 2 überstülpt.
2) Bereits während der Vorheizung oder der Vorheizphase wird das Inertgas, in dieser Ausführung Stickstoff, mit einem Druck von 1,2 bar durch den Gasanschlussstutzen 4 unter die Haube 2 geblasen. Dadurch ist das Bauteil voraggressiven Sauerstoffbestandteilen der Gasatmosphäre geschützt.
3) In der eigentlichen Dampfphasen-Lötphase wird die Zufuhr des Inertgases abgestellt. Das Medium für das Dampfphasen-Löten ist dann so heiß, dass sein Dampf das Bauteil 1 vollständig umhüllt.
4) Nach dem Löten beginnt die Abkühlphase. Hierzu wird wieder Stickstoff unter die Haube 2 geblasen und ersetzt die Dampfatmosphäre des vorhergehenden Schrittes. Diese Atmosphäre kann erhalten bleiben, bis das Bauteil auf Raumtemperatur abgekühlt ist.

Über die Gasmenge und Gastemperatur sowie die Gasart können die Heiz- und Kühlbedingungen mit einfachen Mitteln gesteuert werden.

Als bevorzugte Bemaßungen für die Bearbeitung eines Bauteils mit 200 mm Durchmesser hat sich eine Haube ergeben, die 220 mm Durchmesser hat, eine Höhe von 50 mm und aus einem Blech mit einer Wandstärke von 1 mm gefertigt ist. Der Anschlussstutzen kann bei 6 mm Durchmesser liegen.

## Patentansprüche

1. Dampfphasenbehandlungsverfahren mit Vorwärmen und Abkühlen von Bauteilen (1) vor und nach einer Dampfphasenbehandlung, zum Dampfphasen-Löten von Leiterplatten oder Baugruppen, **dadurch gekennzeichnet, dass** das Vorwärmen und das Abkühlen unter einer über das Bauteil (1) gestülpten Haube (2) erfolgt, in die ein inertes oder reaktives Gas eingeblasen wird.

2. Verfahren nach Anspruch 1, **dadurch gekennzeichnet, dass** die Haube (2) eine dem Bauteil (1) angepasste Form hat.

3. Verfahren nach Anspruch 1 oder 2, **dadurch gekennzeichnet, dass** als Gas Stickstoff, Kohlendioxid, Argon, Helium, Wasserstoff, CF4 oder ein anderes Edelgas und/oder deren Gemische oder ein reaktives oder reduzierendes Gas verwendet werden.

4. Verfahren nach einem der vorhergehenden Ansprüche, **dadurch gekennzeichnet, dass** der Druck beim Einblasen des Gases > 1,0 bar ist, bevorzugt zwischen 1,0 und 3 bar liegt, besonders bevorzugt zwischen 1,2 und 1,5 bar.

5. Verfahren nach einem der vorhergehenden Ansprüche, **gekennzeichnet durch** eine Menge von Inertgas zwischen 1 und 10 Kubikmeter pro Stunde.

6. Verfahren zum Vorwärmen nach einem der vorhergehenden Ansprüche, **dadurch gekennzeichnet, dass** ein vorgewärmtes Gas eingeblasen wird.

## Claims

1. Vapour-phase treatment process which involves preheating and cooling of components (1) before and after a vapour-phase treatment for the vapour-phase soldering of printed circuit boards or subassemblies, **characterized in that** the preheating and the cooling take place under a hood (2) which is placed over the component (1) and into which an inert or reactive gas is blown.

2. Process according to Claim 1, **characterized in that** the hood (2) has a shape matched to the component (1).

3. Process according to Claim 1 or 2, **characterized in that** the gas used is nitrogen, carbon dioxide, argon, helium, hydrogen, CF4 or some other noble gas and/or mixtures thereof or a reactive or reducing gas.

4. Process according to one of the preceding claims, **characterized in that** the pressure when blowing in the gas is > 1.0 bar, preferably between 1.0 and 3 bar, particularly preferably between 1.2 and 1.5 bar.

5. Process according to one of the preceding claims, **characterized by** an inert gas quantity of between 1 and 10 m³/hour.

6. Process for preheating according to one of the preceding claims, **characterized in that** a preheated gas is blown in.

## Revendications

1. Procédé de traitement en phase vapeur avec préchauffage et refroidissement de composants (1) avant et après un traitement en phase vapeur, en particulier pour le brasage en phase vapeur de cartes de circuit ou de modules,
**caractérisé en ce que**
le préchauffage et le refroidissement s'effectuent en dessous d'un capot (2) posé au-dessus du composant (1) et balayé par un gaz inerte ou un gaz réactif.

2. Procédé selon la revendication 1, **caractérisé en ce que** le capot (2) a une forme adaptée à celle du composant (1).

3. Procédé selon les revendications 1 ou 2, **caractérisé en ce qu'**il utilise comme gaz l'azote, le dioxyde de carbone, l'argon, l'hélium, l'hydrogène, le CF4, un autre gaz rare, leurs mélanges et/ou un gaz réactif ou réducteur.

4. Procédé selon l'une des revendications précédentes, **caractérisé en ce que** la pression d'injection de gaz est > 1,0 bar, est de préférence comprise entre 1,0 et 3 bars et de façon particulièrement préférable entre 1,2 et 1,5 bar.

5. Procédé selon l'une des revendications précédentes, **caractérisé en ce que** le débit de gaz inerte est compris entre 1 et 10 mètres cube par heure.

6. Procédé de préchauffage selon l'une des revendications précédentes, **caractérisé en ce que** le gaz de balayage est préchauffé.
